# EUROPÄISCHE PATENTANMELDUNG

(11) **EP 1 388 737 A1**
(43) Veröffentlichungstag der Anmeldung: **11.02.2004**
(21) Anmeldenummer: 02017955.2
(22) Anmeldetag: 09.08.2002
(51) Int. Cl.: G01R 11/24

(54) **Gehäuse für einen Zähler**

(71) Anmelder: Landis+Gyr AG, 6300 Zug (CH)
(72) Erfinder: Haller, Hans-Peter, 6330 Cham (CH)
(74) Vertreter: OK pat AG

(57) **Zusammenfassung**

Bei einem Gehäuse für Zähler, insbesondere für Elektrizitätszähler, Gaszähler, Wärmezähler oder dergleichen, weist das Gehäuse eine Gehäuseabdeckung (4b) auf, mit der eine Anzahl Anschlüsse (14) des Zählers gegen unberechtigten Zugriff abdeckbar ist wobei eine erste Plombierung (6) die Gehäuseabdeckung (4b) sichert. Durch die Gehäuseabdeckung (4b) ist eine weitere zu schützende Zählervorrichtung (18) abgedeckt, die mittels einer zweiten Plombierung (8) gegen unberechtigten Zugriff schützbar ist.

## Beschreibung

Die Erfindung betrifft ein Gehäuse für einen Zähler, insbesondere für Elektrizitätszähler, Gaszähler, Wärmezähler oder dergleichen, wobei das Gehäuse eine Gehäuseabdeckung aufweist.

### Technologischer Hintergrund und Stand der Technik

Bekannt sind Gehäuse, die beispielsweise bei elektrischen/elektronischen Geräten, wie Elektrizitätszähler, Gaszähler, Wärmezähler oder dergleichen, zum Einsatz gelangen. Eine Besonderheit an Zählergehäusen ist, dass sie gegen unberechtigten Zugriff mittels einer Plombierung geschützt werden. Hierfür verbindet diese Plombierung in der Regel die Gehäuseabdeckung mit dem Gehäuseboden, wobei unter anderem die Zähleranschlüsse abgedeckt werden.

Zumeist sind Gehäuseabdeckungen dieser Art zweiteilig ausgeführt, insbesondere bei Elektrizitätszählern. Eine erste, obere Gehäuseabdeckung verschliesst dabei den Messsignalerfassungs- bzw. den Elektronikteil des Zählers und eine zweite, untere Gehäuseabdeckung schützt die Anschlüsse zum Zähler.

Dieser die Zähleranschlüsse verschliessende Abdeckungsteil wird auch Klemmendeckel genannt. Mittels eines solchen Klemmendeckels wird bei Elektrizitätszählern der gesamte Anschlussklemmenbereich geschützt nebst den zu Prüfzwecken in unmittelbarer Nähe ebenfalls installierten, sogenannten Spannungsbrücken. Derartige Spannungsbrücken erlauben ein einfaches Trennen der Messzweige für die Spannungsmessung und die Strommessung zum Abgleich dieser Messpfade bzw. zur Eichprüfung.

Eine Ausführungsform derartiger Spannungsbrücken umfasst herkömmliche, verschraubbare Schiebebrücken; eine andere Ausgestaltungsform sieht hingegen eine Kontaktfederbrükkenanordnung vor, wie sie in der CH 683801 gezeigt ist. Diese Kontaktfederbrücke ermöglicht eine äusserst einfache Bedienung bei der Trennung der Messpfade, da lediglich eine elektrische Prüfspitze derart eingeführt werden muss, dass die Kontaktfeder die Messkreise trennt und gleichzeitig den Spannungsmesspfad mit einer Prüfspannung beaufschlagt. Der Zugang zu diesen Kontaktfedern erfolgt durch Führungsbohrungen in einer Gehäusewand zwischen dem Anschlussklemmenblock und dem Inneren des Zählers mit dem Mess- bzw. Elektronikteil.

Bei langjährigem Einsatz von Zählern mit Spannungsbrücken in Form von Kontaktfedern hat sich gezeigt, dass bei geöffnetem Klemmendeckel am Installationsort der Zähler eine unzulässige, auf Anhieb schlecht nachweisbare Manipulation der Spannungsbrücken erfolgen kann, was im ungünstigsten Fall sogar zum Ausfall des gesamten Zählers führen kann.

### Darstellung der Erfindung

Es ist deshalb Aufgabe der Erfindung Gehäuse der oben beschriebenen Art dahingehend weiterzubilden, dass unter Ausnutzung aller Vorteile der oben beschriebenen, komfortablen Spannungsbrücke in Form der Kontaktfederanordnung, ein verbesserter Schutz gegen unberechtigte Manipulation gewährt wird.

Diese Aufgabe wird erfindungsgemäss gelöst durch die Merkmale des Anspruchs 1.

Der Kern der Erfindung ist darin zu sehen, dass bei einem Gehäuse für einen Zähler mittels einer plombierbaren Gehäuseabdeckung, die die Zähleranschlüsse abdeckt, mindestens eine weitere Zählervorrichtung abgedeckt ist, die mittels einer zweiten Plombierung gegen unberechtigten Zugriff schützbar ist.

Eine konkrete Ausführungsform sieht vor, dass auf vorteilhafte Weise mit der Erfindung eine Spannungsbrücke eines Elektrizitätszählers mit einer zusätzlichen Plombierung selbst dann noch geschützt ist, wenn der sie ebenfalls abdeckende und ansonsten ebenfalls plombierte Klemmendeckel nicht installiert ist. Derartige klemmendeckelfreie Zustände sind vor allem dort bekannt, wo mit einer ersten Gehäuseabdeckung lediglich grösster Wert auf den Schutz der Mess- bzw. Elektronikeinheit eines Zählers gelegt wird und der Schutz der Zähleranschlüsse mittels einer zweiten Gehäuseabdeckung in Form eines Klemmendekkels zumindest zeitweise vernachlässigt wird. In solchen Fällen ist von grösstem Vorteil, dass an dem Zählergehäuse zum Schutz der Spannungsbrücke eine weitere, eigene Plombierung vorgesehen ist. Herauszuheben ist dabei, dass diese erfindungsgemässe Plombierung einer weiteren zu schützenden Zählervorrichtung so gestaltet ist, dass sie bei klemmendeckelfreiem Zustand frei zugänglich ist und somit visuell einfach und schnell überprüfbar ist.

Weitere vorteilhafte Ausgestaltungen der Erfindung sind Gegenstand der abhängigen Ansprüche 2 bis 16.

Mit Vorteil wird die zu schützende Zählervorrichtung mit einer Zusatzabdeckung abgedeckt ist, wobei diese Zusatzabdeckung gegen unberechtigtes Entfernen plombiert wird.

Besonders einfach und sicher ist die Verwendung eines Riegels als Zusatzabdeckung, der in Gehäusenuten und/oder hinter Gehäusestegen gehalten wird und eine frei zugängliche Plombierbohrung zur Sicherung aufweist.

Eine vorteilhafte Ausgestaltung der Erfindung sieht vor, dass das Zählergehäuse mindestens eine Plombieröse aufweist, mit der die Plombierbohrung der Zusatzabdeckung zusammenwirkt, wobei ein Plombierstift durch die mindestens eine Plombieröse und die Plombierbohrung als Bindeglied funktioniert. Dabei ist besonders vorteilhaft, wenn die mindestens eine Plombieröse von der Plombierbohrung beabstandet angeordnet ist, so dass eine Sollbruchstelle des Plombierstiftes zwischen ihnen sichtbar ist.

Darüber hinaus ist vorteilhaft, wenn das Gehäuse eine zweite Plombieröse aufweist, die von der mindesten einen, ersten Plombieröse beabstandet angeordnet ist, wobei sich zwischen diesen Plombierösen eine Art Sichtfenster für die Sollbruchstelle des Plombierstiftes ergibt. Dabei kann die Plombierbohrung entweder innerhalb oder ausserhalb dieses Sichtfensters angeordnet sein.

Von besonderem Vorteil ist, wenn der Plombierstift aus einem Kunststoff besteht, insbesondere aus einem transparenten Kunststoff, da somit eine Überprüfung desselben einfach und schnell möglich ist. Transparente Plombierstifte offenbaren nämlich unmittelbar jede an ihnen verübte Manipulation.

Mit Vorteil tragen die Plombierstifte nach ihrer Installation einen Prägestempelung mit Hinweisen auf die Eichbehörde und/oder das Eichdatum.

### Kurze Darstellung der Zeichnung

In der Zeichnung ist ein Ausführungsbeispiel der Erfindung vereinfacht dargestellt. Es zeigt:
- Fig. 1: eine perspektivische Schnittdarstellung eines erfindungsgemässen Gehäuses mit einer plombierbaren Zusatzabdeckung unter einem plombierbaren Klemmendeckel;
- Fig. 2: eine als Riegel ausgebildete Zusatzabdeckung;
- Fig. 3: eine perspektivische Darstellung einer erfindungsgemäss zu schützenden Spannungsbrücke (Stand der Technik, CH 683801), und
- Fig. 4: eine Plombierung des Riegels.

Im folgenden wird die Erfindung anhand der Zeichnung detailliert erörtert. Dabei ist anzumerken, dass die Erfindung keinesfalls auf die Darstellung in dieser Zeichnung zu reduzieren ist. So ist beispielsweise nicht nur eine Spannungsbrücke mit der Erfindung schützbar, sondern jede weitere Zusatzvorrichtung eines Zählers, die selbst dann noch plombiert sein muss, wenn ein zugehöriges Zählergehäuseabdeckungsteil nicht installiert ist.

### Wege zur Ausführung der Erfindung

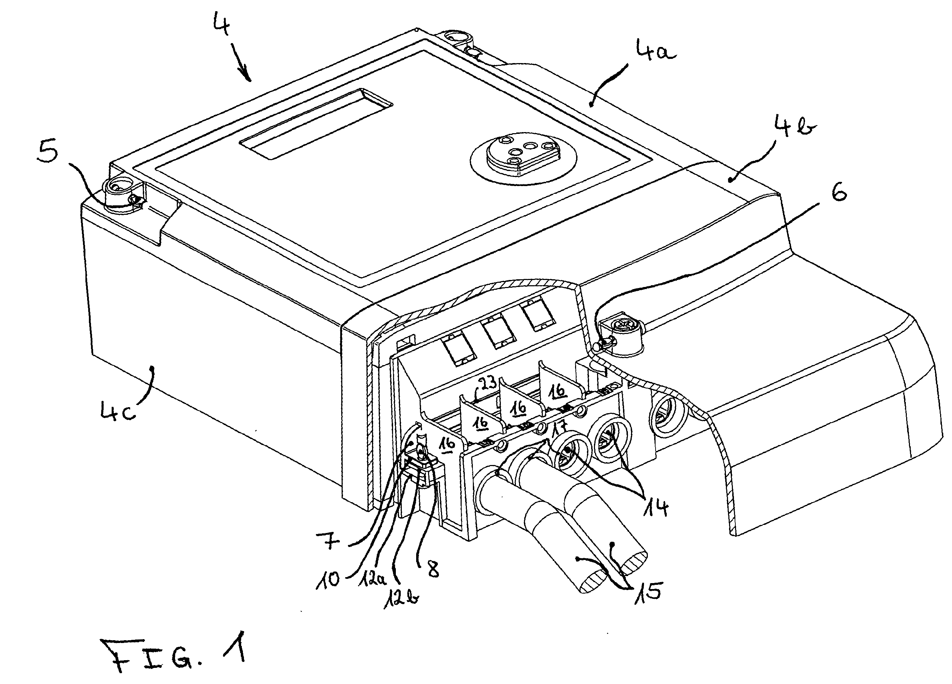

Fig. 1 zeigt in einer perspektivischen Schnittdarstellung ein Zählergehäuse 4. Dieses Zählergehäuse 4 ist als Elektrizitätszählergehäuse ausgebildet und hier lediglich als spezielle Ausgestaltung eines im allgemeinen bekannten Zählergehäuses anzusehen. Das Zählergehäuse 4 umfasst ein Gehäuseunterteil 4c, das von einer ersten Gehäuseabdekkung 4a und von einer zweiten Gehäuseabdeckung 4b verschlossen wird. Die zweite Gehäuseabdeckung 4b ist in dem vorliegenden Fall als Klemmendeckel ausgebildet und wird im Folgenden auch so benannt.

Gegen unbefugten Zugriff ist sowohl die erste Gehäuseabdeckung 4a, wie auch der Klemmendeckel 4b jeweils mit einer Plombierung 5 bzw. 6 versehen. Der Klemmendeckel 4b schützt die unter ihm angeordneten Klemmen 14 und daran angeschlossenen Leiter 15. Die Leiter 15 sind durch Anschlussöffnungen 17 im Gehäuseunterteil 4c in die Klemmen 14 geführt angeordnet.

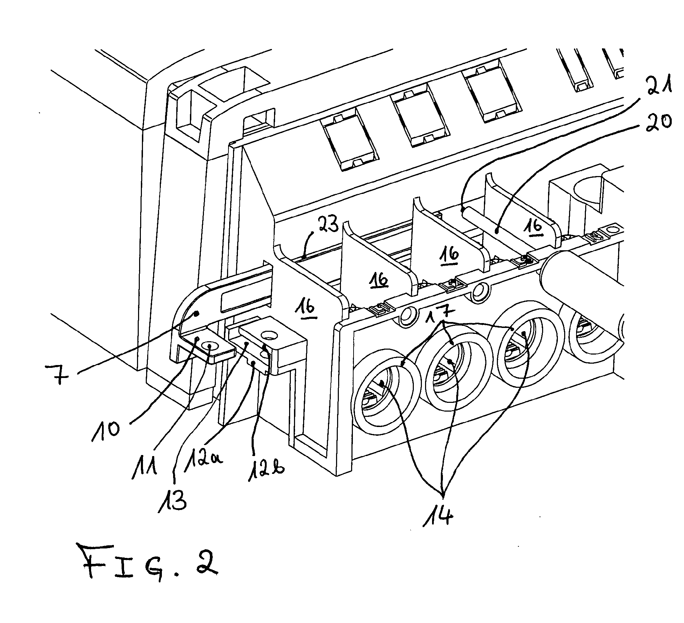

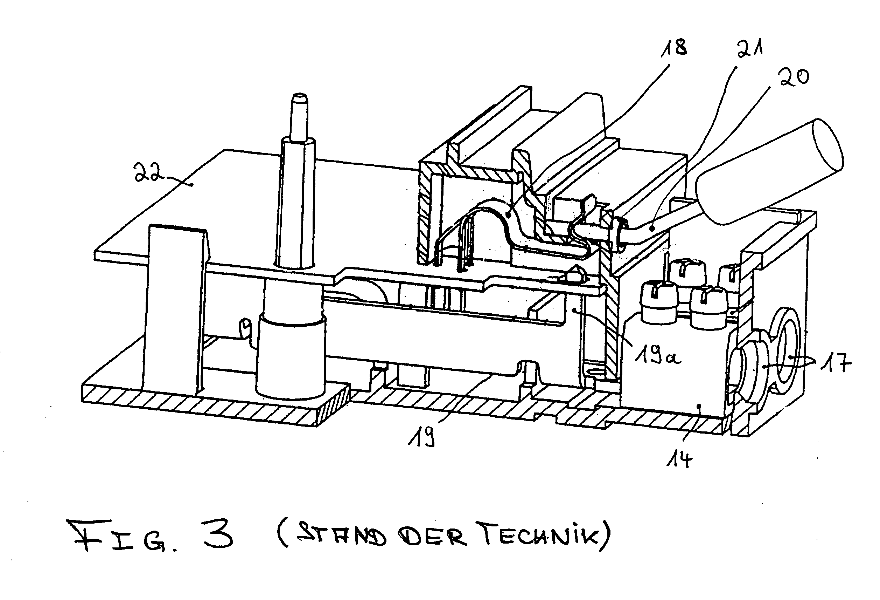

Neben den zugriffsgeschützten Klemmen 14 und Leitern 15 wird durch eine Zusatzabdeckung 7 in Form eines Riegels eine weitere - hier nicht dargestellte - zu schützende Zusatzvorrichtung 18, bzw. Zugangsöffnungen 21 dazu, abgedeckt, die weiter unten in Verbindung mit den Fig. 2 und 3 näher erläutert werden.

An dem Riegel 7 ist eine Konsole 10 angeformt, mit der der Riegel an mindestens einer der Plombierösen 12a oder 12b des Gehäuseunterteils 4c plombiert ist. Der Riegel selbst ist in einer Gehäusenut 23 seitlich gehaltert und durch eine Anzahl Gehäusestege 16 in dieser Gehäusenut 23 fixiert.

Die Fig. 2 und die Fig. 3 zeigen, eine Prüföffnung 21, die von einem plombierten Riegel 7, wie er in Fig. 1 gezeigt ist, abgedeckt ist. Eine derartige Prüföffnung 21 erlaubt den Zugriff zu einer in dem Gehäuse 4 installierten Spannungsbrücke 18. Um diese Prüföffnung zu bedienen, ist der Riegel 7 in Fig. 2 in Nutrichtung der Gehäusenut 23 etwas herausgezogen gezeigt.

Eine bekannte Spannungsbrücke 18 ist als Federkontakt in Fig. 3 dargestellt. Sie dient bei Elektrizitätszählern dazu, einen Spannungsmesskreis von einem Strommesskreis während eines Eichprozesses zu trennen. Die Federkontaktausführung ist besonders vorteilhaft wegen der schnellen und einfachen Bedienbarkeit. So muss zu Eichzwecken lediglich eine Prüfspitze 20 durch die Prüföffnung 21 eingeführt werden, wobei der Federkontakt 18 des Spannungsmesskreises von einem Brückenkontakt 19a eines Stromleiters 19 abgehoben wird, und wobei gleichzeitig der auf einer Leiterplatte 22 angeordnete Federkontakt 18 mit einer Prüfspannung beaufschlagt wird.

Im klemmendeckelfreien Zustand waren die Prüföffnungen 21 unverschlossen und eröffneten somit eine unerwünschte Zugriffsmöglichkeit auf den Federkontakt 18. Das erfindungsgemässe Zählergehäuse 4 bewahrt sich nun weiterhin die einfache Bedienbarkeit der Spannungsbrücke 18 zu Prüfzecken, gewährleistet aber gleichzeitig mit dem plombierten Riegel 7 einen einwandfreien und darüber hinaus leicht überprüfbaren Schutz gegen unberechtigten Zugriff.

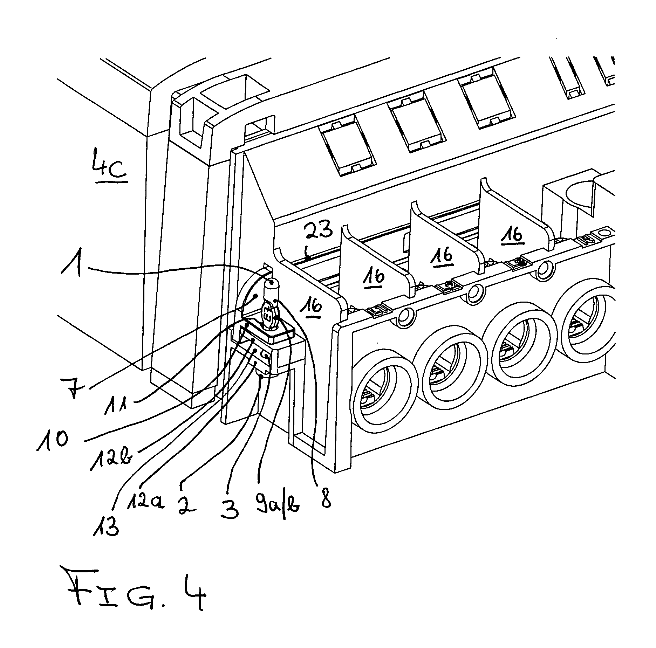

Die Fig. 4 zeigt den plombierten Riegel 7 in vergrösserter Darstellung. Ein Plombierstift 1 verbindet den Riegel 7 mit dem Gehäuseunterteil 4c. Hierfür ist vorgesehen, dass dieser Plombierstift durch eine erste Plombieröse 12a und eine zweite Plombieröse 12b des Gehäuseunterteils 4c und durch die Plombierbohrung 11 der Riegelkonsole 10 geführt wird und anschliessend mittels einer plastischen Verformung 9a gesichert wird.

Einseitig endet der Plombierstift 1 mit einem Stiftkopf 2. Vor einem Plombiervorgang und einer damit verbundenen Fixierung des Plombierstifts 1, weist dieser eine im wesentlichen konstante Dicke auf, mit Ausnahme einer Sollbruchstelle 3, an der der Plombierstift eine entsprechende Verjüngung aufweist. Diese Sollbruchstelle 3 ist derart am Plombierstift angeordnet, dass sie innerhalb der eines Sicht- bzw. Überprüfungsfensters 13 zwischen der ersten und der zweiten Plombieröse 12a, 12b sichtbar ist, wenn der Plombierstift 1 fixiert ist.

Die Riegelkonsole 10 ist ausserhalb des Sichtfensters 13 neben der ersten und/oder zweiten Plombieröse 12a, 12b angeordnet. Selbstverständlich ist ebenfalls denkbar, die Riegelkonsole 10 innerhalb des Sichtfensters 13 zu lokalisieren; allerdings muss das Sichtfenster 13 dann so gestaltet sein, dass dennoch die Sollbruchstelle 3 des Plombierstifts 1 sichtbar bleibt.

Das Sicht- bzw. Überwachungsfenster 13 für die Sollbruchstelle 3 ist klein genug ist, um vor einer unberechtigten Manipulation zu schützen, und ermöglicht darüber hinaus bei dennoch erfolgter Manipulation ein äusserst einfaches Erkennen. Es kann nämlich als unmöglich angesehen werden, den Plombierstift 1 durch Zerstören der Sollbruchstelle 3 zu entfernen, und anschliessend denselben Plombierstift 1 repariert in diesem Überwachungsfenster 13 anzuordnen, ohne dass ein einfacher Kontrollblick diese betrügerische Massnahme unmittelbar offen legen würde.

Eine weitere Verbesserung der Überprüfbarkeit der Plombierung 8 ergibt sich, wenn der Plombierstift 1 aus einem transparenten Kunststoff gefertigt ist, da eine Manipulation stärker ans Licht treten würde.

Die plastische Verformung 9a des Plombierstifts 1 ist mit einem Prägestempelung 9b versehen. Da die plastische Verformung 9a eine Vorderseite und eine Rückseite umfasst, zeigt die Vorderseite das eingeprägte Prüfdatum und die Rückseite eine Kennung der prüfenden Behörde.

### BEZUGSZEICHENLISTE

- 1: Plombierstift
- 2: Stiftkopf
- 3: Sollbruchstelle
- 4: Zählergehäuse
- 4a: Gehäuseabdeckung
- 4b: Klemmendeckel
- 4c: Gehäuseunterteil
- 5: Plombierung der Gehäuseabdeckung 4a
- 6: Plombierung des Klemmendeckels 4b
- 7: Riegel
- 8: Plombierung des Riegels 7
- 9a: plastische verformung
- 9b: Prägestempelung
- 10: Konsole
- 11: Plombierbohrung
- 12a: erste Plombieröse
- 12b: zweite Plombieröse
- 13: Sichtfenster
- 14: Klemmen
- 15: Leiter
- 16: Gehäusestege
- 17: Anschlussöffnungen
- 18: Spannungsbrücke/Federkontakt
- 19: Stromleiter
- 19a: Brückenkontakt
- 20: Prüfspitze
- 21: Prüföffnung
- 22: Leiterplatte
- 23: Gehäusenut

## Patentansprüche

1. Gehäuse für einen Zähler, insbesondere für einen Elektrizitätszähler, Gaszähler, Wärmezähler oder dergleichen, wobei das Gehäuse eine Gehäuseabdeckung (4b) aufweist,
mit welcher Gehäuseabdeckung (4b) eine Anzahl Anschlüsse (14) des Zählers (1) gegen unberechtigten Zugriff abdeckbar ist, und wobei eine erste Plombierung (6) die Gehäuseabdeckung (4b) sichert,
**dadurch gekennzeichnet,**
**dass** das durch die Gehäuseabdeckung (4b) eine weitere zu schützende Zählervorrichtung (18) abgedeckt ist, die mittels einer zweiten Plombierung (8) gegen unberechtigten Zugriff schützbar ist.

2. Gehäuse nach Anspruch 1,
**dadurch gekennzeichnet,**
**dass** die zu schützende Zählervorrichtung (18) mittels einer Zusatzabdeckung (7) abgedeckt ist.

3. Gehäuse nach Anspruch 2,
**dadurch gekennzeichnet,**
**dass** die Zusatzabdeckung (7) als Riegel ausgebildet ist, der seitlich in einer Anzahl entsprechend angeordneter Gehäusenuten (23) gehalten ist.

4. Gehäuse nach Anspruch 2,
**dadurch gekennzeichnet,**
**dass** die Zusatzabdeckung (7) als Riegel ausgebildet ist, der von einer Anzahl entsprechend angeordneter Gehäusestegen (16) gehalten ist.

5. Gehäuse nach einem der Ansprüche 1 bis 4,
**dadurch gekennzeichnet,**
**dass** die Zusatzabdeckung (7) eine Plombierbohrung (11) aufweist und das Gehäuse eine erste Plombieröse (12a) aufweist, so dass die Zusatzabdeckung (7) durch ihre Plombierbohrung (11) an der Plombieröse (12a) plombierbar ist.

6. Gehäuse nach Anspruch 5,
**dadurch gekennzeichnet,**
**dass** das die Zusatzabdeckung (7) mittels eines Plombierstifts (1) sicherbar ist.

7. Gehäuse nach Anspruch 6,
**dadurch gekennzeichnet,**
**dass** die erste Plombieröse (12a) von der Plombierbohrung (11) beabstandet ist, so dass zwischen der ersten Plombieröse (12a) und der Plombierbohrung (11) eine Sollbruchstelle (3) des Plombierstifts (1) sichtbar angeordnet ist.

8. Gehäuse nach Anspruch 6 oder 7,
**dadurch gekennzeichnet,**
**dass** das Gehäuse eine weitere, zweite Plombieröse (12b) aufweist, die von der ersten Plombieröse (12a) beabstandet angeordnet ist, wobei in einem Zwischenraum (13) zwischen der ersten und der zweiten Plombieröse (12a, 12b) eine Sollbruchstelle (3) des Plombierstifts () sichtbar angeordnet ist.

9. Gehäuse nach Anspruch 8,
**dadurch gekennzeichnet,**
**dass** die Plombierbohrung (11) der Zusatzabdeckung (7) in dem Zwischenraum (13) angeordnet ist.

10. Gehäuse nach Anspruch 8,
**dadurch gekennzeichnet,**
**dass** die Plombierbohrung (11) der Zusatzabdeckung (7) ausserhalb des Zwischenraums (13) angeordnet ist.

11. Plombierung nach einem der Ansprüche 6 bis 10,
**dadurch gekennzeichnet,**
**dass** der Plombierstift (1) aus einem Kunststoff, einem Metall oder einer Metalllegierung besteht.

12. Plombierung nach einem der Ansprüche 6 bis 11,
**dadurch gekennzeichnet,**
**dass** der Plombierstift (1) aus einem transparenten Kunststoff besteht.

13. Plombierung nach einem der Ansprüche 6 bis 12,
**dadurch gekennzeichnet,**
**dass** der Plombierstift (1) an einem Ende einen Stiftkopf (2) aufweist, und dass an dem anderen Ende der Plombierstift mittels einer plastischen Verformung (9a) plombierbar ist.

14. Plombierung nach Anspruch 13,
**dadurch gekennzeichnet,**
**dass** der Plombierstift (1) an der plastischen Verformung (9a) eine Prägestempelung (9b) aufweist.

15. Plombierung nach Anspruch 14,
**dadurch gekennzeichnet,**
**dass** die Prägestempelung (9b) ein Prüfdatum und/oder eine Kennung einer Plombierungsbehörde aufweist.

16. Gehäuse nach einem der vorstehenden Ansprüche,
**dadurch gekennzeichnet,**
**dass** die weitere zu schützende Zählervorrichtung (18) eine oder mehrere Spannungsbrücken umfasst, die durch eine oder mehrere Prüföffnungen (21) zugänglich sind.
